# FASCICULE DE BREVET EUROPEEN

(11) **EP 1 773 512 B1**
(45) Date de publication et mention de la délivrance du brevet: **26.05.2010**
(21) Numéro de dépôt: 05763073.3
(22) Date de dépôt: 05.07.2005
(51) Int. Cl.: B05D 7/22

(54) **PROCEDE DE TRAITEMENT D'UN RECIPIENT COMPORTANT DES PHASES DE POMPAGE A VIDE ET MACHINE POUR SA MISE EN OEUVRE**
BEHÄLTERBEHANDLUNGSVERFAHREN MIT VAKUUMPUMPPHASEN UND MASCHINE ZU DESSEN AUSFÜHRUNG
CONTAINER-TREATMENT METHOD COMPRISING VACUUM PUMPING PHASES, AND MACHINE FOR IMPLEMENTING SAME

(30) Priorité: 08.07.2004 FR 0451474
(43) Date de publication de la demande: 18.04.2007
(73) Titulaire: SIDEL PARTICIPATIONS, 76930 Octeville-sur-Mer (FR)
(72) Inventeur: DANEL, Laurent, Sidel, F-76930 Octeville Sur Mer (FR); LECOMTE, Frédéric, Sidel, F-76930 Octeville Sur Mer (FR); CHOMEL, Nicolas, Sidel, F-76930 Octeville Sur Mer (FR)
(74) Mandataire: Kohn, Philippe
(86) Numéro de dépôt international: PCT/EP2005/053203
(87) Numéro de publication internationale: WO 2006/005698

(56) Documents cités:
- EP-A- 0 773 167
- WO-A-95/22413
- DE-A1- 4 318 086
- US-A- 5 690 745

## Description

La présente invention concerne un procédé et une machine de traitement de récipients en matériau plastique tels que les bouteilles en polyéthylène téréphtalate (PET).

La présente invention concerne plus particulièrement un procédé de traitement d'au moins un récipient visant à réaliser le dépôt d'un revêtement interne formant barrière au moyen d'un plasma micro-ondes, notamment en vue de permettre le conditionnement de liquides oxydo-sensibles dans le récipient, du type dans lequel le récipient est disposé à l'intérieur d'une enceinte de traitement hermétiquement fermée qui délimite une cavité à l'extérieur du récipient et qui est raccordée à un circuit de pompage à vide par un conduit de vide externe, l'intérieur du récipient étant raccordé au circuit de pompage par un conduit de vide interne, du type comportant une étape préliminaire au cours de laquelle le circuit de pompage provoque une diminution de la pression à l'intérieur de la cavité jusqu'à une valeur déterminée dite valeur finale externe et une diminution de la pression à du récipient jusqu'à une valeur déterminée dite valeur finale interne, l'étape préliminaire étant suivie d'une étape de traitement au cours de laquelle les valeurs finales sont maintenues dans la cavité et dans le récipient pour permettre le dépôt du revêtement interne dans le récipient.

Le document DE-A-4318086 décrit le traitement de récipients en matière plastique à l'aide d'une installation comprenant un conduit à vide interne et externe.

Au cours de l'étape de traitement, un fluide précurseur (par exemple à base d'acétylène dans le cas de la réalisation d'un revêtement carboné, ou un composé organosilicé dans le cas d'un dépôt à base de silice) est injecté dans le récipient et soumis à l'action de micro-ondes de sorte qu'il passe à l'état de plasma et provoque un dépôt barrière sur les parois internes du récipient.

Pour pouvoir réaliser ce dépôt, il est nécessaire de faire le vide à l'intérieur du récipient et dans la cavité, et de maintenir ce vide pendant toute l'étape de traitement.

Généralement la pression recherchée à l'intérieur du récipient est d'environ 0,1 mbar et la pression recherchée à l'intérieur de la cavité est d'environ 50 mbar.

Il est connu de mettre en oeuvre l'étape préliminaire en pompant simultanément dans la cavité et dans le récipient, jusqu'à ce que la pression dans la cavité atteigne la valeur finale externe (environ 50 mbar).

Un dispositif d'obturation vient alors fermer hermétiquement la cavité, pour permettre de descendre la pression à l'intérieur du récipient jusqu'à la valeur finale interne qui est inférieure à la valeur finale externe.

Le pompage simultané dans la cavité et dans le récipient peut poser des problèmes importants car il est difficile de contrôler la vitesse à laquelle la pression diminue dans chacun des deux éléments.

En effet, en fonction notamment des sections de passage de l'air aspiré dans le récipient et dans la cavité, de la forme du récipient, il arrive que le vide se fasse très rapidement dans le récipient et plus lentement dans la cavité, de sorte que pendant un laps de temps déterminé, la différence de pression entre l'intérieur du récipient et la cavité atteint une valeur supérieure aux capacités de résistance mécanique à l'écrasement du récipient.

Généralement, un récipient en PET ne supporte pas plus de 70 à 80 mbar en dépression.

La différence de pression entre les deux éléments provoque donc l'écrasement du récipient sur lui-même, ce qui entraîne la mise au rebut du récipient et éventuellement un arrêt de la machine de traitement.

Pour éviter ces problèmes, il est possible d'augmenter la résistance mécanique du récipient, par exemple en augmentant l'épaisseur des parois.

Cette solution n'est pas satisfaisante car elle conduit à augmenter le poids et le coût du récipient.

La résistance mécanique du récipient peut aussi être augmentées en choisissant une forme adaptée.

Cette solution n'est pas non plus satisfaisante car elle constitue une contrainte technique qui empêche de choisir librement la forme extérieure du récipient.

L'invention vise notamment à remédier à ces inconvénients de manière simple et économique.

Dans ce but, l'invention propose un procédé de traitement du type décrit précédemment, caractérisé en ce que l'étape préliminaire comporte successivement :
- une phase de pompage externe, au cours de laquelle le conduit de vide interne est fermé et le conduit de vide externe est ouvert, le circuit de pompage provoquant la diminution de la pression uniquement dans la cavité, jusqu'à une valeur déterminée qui est supérieure ou égale à la valeur finale externe,
- et, une phase de pompage interne, au cours de laquelle le conduit de vide externe est fermé et le conduit de vide interne est ouvert, le circuit de pompage provoquant la diminution de la pression uniquement à l'intérieur du récipient, jusqu'à la valeur finale interne.

Selon une autre caractéristique de l'invention, pendant la phase de pompage externe, le circuit de pompage diminue la pression dans la cavité jusqu'à une valeur intermédiaire qui est supérieure à la valeur finale externe, et il est prévu une phase intermédiaire de pompage, entre la phase de pompage externe et la phase de pompage interne, au cours de laquelle le conduit de vide externe et le conduit de vide interne sont ouverts simultanément de manière que le circuit de pompage diminue simultanément la pression dans la cavité et à l'intérieur du récipient, jusqu'à ce que la pression dans la cavité atteigne la valeur finale externe.

L'invention propose aussi une machine de traitement de bouteilles pour la mise en oeuvre du procédé selon l'une des caractéristiques précédentes, comportant au moins un poste de traitement pour au moins un récipient, chaque poste de traitement comprenant :
- une enceinte de traitement qui est prévue pour contenir au moins un récipient et qui délimite autour du récipient une cavité raccordée de manière étanche à un conduit de vide externe,
- et, un conduit de vide interne raccordé de manière étanche à l'intérieur du récipient,
du type dans laquelle le conduit de vide externe et le conduit de vide interne sont raccordés à un circuit de pompage à vide commun, le conduit de vide interne communiquant avec le circuit de pompage par l'intermédiaire d'un premier dispositif d'obturation commandé et le conduit de vide externe communiquant avec le circuit de pompage par l'intermédiaire d'un second dispositif d'obturation commandé,
caractérisée en ce que le conduit de vide externe est raccordé directement au circuit de pompage, sans passer par le conduit de vide interne, et en ce que le premier dispositif d'obturation est commandé de manière à permettre le pompage dans la cavité indépendamment du pompage dans le récipient.

Selon d'autres caractéristiques de la machine selon l'invention :
- au moins un dispositif d'obturation est constitué par une soupape commandée par un système à came ;
- au moins un dispositif d'obturation est constitué par une électrovanne.

D'autres caractéristiques et avantages de l'invention apparaîtront à la lecture de la description détaillée qui suit pour la compréhension de laquelle on se reportera aux dessins annexés dans lesquels :
- la figure 1 est une vue en coupe axiale qui représente schématiquement un poste de traitement d'une machine réalisée conformément aux enseignements de l'invention et qui illustre une phase de pompage externe ;
- la figure 2 est une vue similaire à celle de la figure 1 qui illustre une phase de pompage interne.

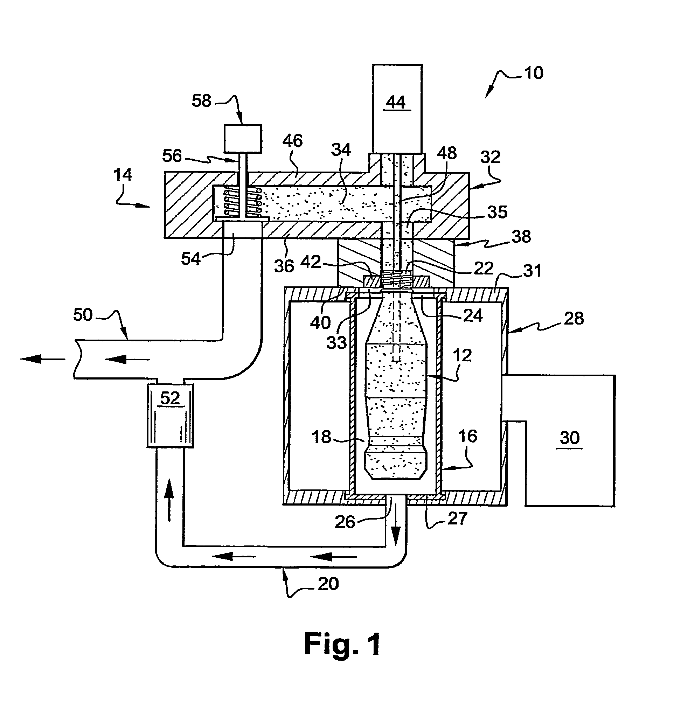

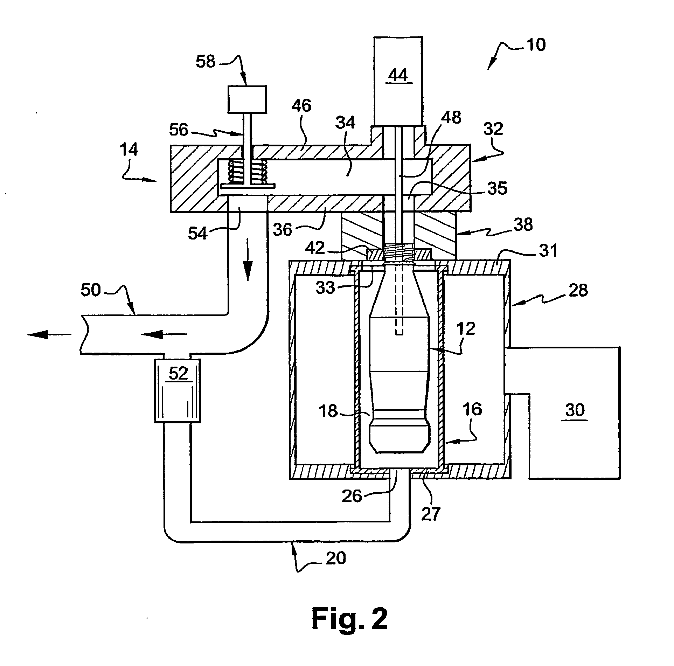

Sur les figures 1 et 2, on a représenté schématiquement une machine 10 de traitement de récipients 12, constitués ici par des bouteilles 12, pour la mise en oeuvre du procédé selon l'invention.

La machine 10 peut être réalisée sous la forme d'un carrousel comprenant une série de postes de traitement 14 identiques qui sont répartis circonférentiellement autour d'un axe de rotation principal.

Les figures 1 et 2 représentent partiellement un poste de traitement 14 prévu pour une bouteille 12.

Le poste de traitement 14 comporte une enceinte 16 de traitement qui est prévue pour contenir la bouteille 12 et qui délimite, autour de la bouteille 12, une cavité 18 raccordée de manière étanche à un conduit de vide externe 20. L'enceinte 16 est réalisée en un matériau transparent aux micro-ondes, typiquement du quartz.

La bouteille 12 est ici agencée verticalement dans l'enceinte 16 de manière que son col 22 s'étende vers le haut à travers une ouverture supérieure 24 correspondante de l'enceinte 16.

Pour la suite de la description, on définit, à titre non limitatif, une direction axiale verticale suivant l'axe vertical de la bouteille, et une direction transversale par rapport à cette direction axiale.

Avantageusement, le conduit de vide externe 20 débouche dans la cavité 18 à travers une ouverture inférieure 26 qui est réalisée dans la paroi transversale inférieure 27 de l'enceinte 16.

L'enceinte 16 est elle-même contenue dans un caisson 28 qui est associé à un générateur 30 de micro-ondes.

L'extrémité axiale supérieure de l'enceinte 16 est en contact étanche avec la paroi transversale supérieure 31 du caisson 28, de manière que l'ouverture supérieure 24 de l'enceinte 16 soit agencée en regard d'une ouverture 33 associée aménagée dans ladite paroi transversale supérieure 31.

Le poste de traitement 14 comporte un couvercle 32 qui est prévu pour fermer l'ouverture supérieure 24 de l'enceinte 16 de manière hermétique et qui comporte un conduit de vide interne 34, ou chambre de pompage, raccordé de manière étanche avec l'intérieur de la bouteille 12.

Selon le mode de réalisation représenté ici, la paroi transversale inférieure 36 du couvercle 32 est munie d'une tuyère 38 de forme tubulaire qui s'étend axialement vers le bas et qui comporte une surface annulaire 40 transversale inférieure venant en appui axial étanche contre la paroi transversale supérieure 31 du caisson 28 de manière à fermer l'ouverture 33 du caisson 28 et l'ouverture supérieure 24 de l'enceinte 16.

La tuyère 38 permet le raccordement étanche du conduit de vide interne 34 avec l'intérieur de la bouteille 12 à travers un passage 35 aménagé dans la paroi transversale inférieure 36 du couvercle 32.

La tuyère 38 est pourvue d'un dispositif de préhension 42 qui est prévu pour saisir la bouteille 12 extérieurement par son col 22.

Un injecteur 44 de fluide précurseur est agencé sur la paroi transversale supérieure 46 du couvercle 32. L'injecteur 44 comporte un tube d'injection 48 qui s'étend axialement vers le bas à travers le couvercle 32 et à travers le col 22 de la bouteille 12.

Le conduit de vide externe 20 et le conduit de vide interne 34 sont raccordés à un circuit de pompage 50 à vide commun.

Le circuit de pompage 50 est relié à une pompe à vide (non représentée).

Conformément aux enseignements de l'invention, le conduit de vide externe 20 est raccordé directement au circuit de pompage 50 par l'intermédiaire d'un dispositif d'obturation 52 commandé, par exemple une électrovanne.

Le conduit de vide externe 20 n'est pas raccordé au conduit de vide interne 34 du couvercle 32.

Le conduit de vide interne 34 communique avec le circuit de pompage 50 par l'intermédiaire d'un orifice de raccordement 54 qui est réalisé ici dans la paroi transversale inférieure 36 du couvercle 32.

De préférence, comme illustré sur les figures, l'orifice de raccordement 54 est pourvu d'un dispositif d'obturation 56 commandé de manière à permettre le pompage dans la cavité 18 indépendamment du pompage dans la bouteille 12.

Le dispositif d'obturation 56 commandé équipant l'orifice de raccordement 54 peut être commandé par tout actionneur 58 approprié (actionneur à came ou, de préférence, actionneur électromagnétique, de sorte que dans ce cas le dispositif d'obturation 56 commandé constitue une électrovanne).

On décrit maintenant un procédé de traitement d'un récipient, constitué par une bouteille, conforme aux enseignements de l'invention et mis en oeuvre au moyen de la machine 10 qui vient d'être décrite.

Le procédé de traitement vise à réaliser le dépôt d'un revêtement appelé couche barrière sur les parois internes de la bouteille 12 au moyen d'un plasma micro-ondes, notamment en vue de permettre le conditionnement de liquides oxydo-sensibles dans la bouteille 12.

Le procédé de traitement comporte une étape préliminaire E1 au cours de laquelle le circuit de pompage 50 provoque une diminution de la pression à l'intérieur de la cavité 18 jusqu'à une valeur déterminée dite valeur finale externe pFext et une diminution de la pression à l'intérieur de la bouteille 12 jusqu'à une valeur déterminée dite valeur finale interne pFint qui est inférieure à la valeur finale externe pFext.

L'étape préliminaire E1 est suivie d'une étape de traitement E2 au cours de laquelle les valeurs finales pFext, pFint sont maintenues dans la cavité 18 et dans la bouteille 12 pour permettre le dépôt du revêtement interne dans la bouteille 12.

Conformément aux enseignements de l'invention, l'étape préliminaire E1 comporte successivement une phase de pompage externe P1, qui est illustrée par la figure 1, et une phase de pompage interne P2, qui est illustrée par la figure 2.

Au cours de la phase de pompage externe P1, Le dispositif d'obturation 56 est commandé en position fermée, tel que représenté sur la figure 1, ce qui ferme la communication entre le conduit de vide interne 34 et le circuit de pompage 50, et le dispositif d'obturation 52 est commandé en position ouverte ce qui fait communiquer le conduit de vide externe 20 avec le circuit de pompage 50.

Le circuit de pompage 50 provoque alors une diminution de la pression uniquement dans la cavité 18, jusqu'à la valeur finale externe pFext, apte à permettre le traitement de la bouteille 12.

Pendant la phase de pompage externe P1, la pression dans la bouteille 12 et dans le conduit de vide interne 34 reste sensiblement constante.

Au cours de la phase de pompage interne P2, le dispositif d'obturation 52 est commandé en position fermée, ce qui ferme la communication entre le conduit de vide externe 20 et le circuit de pompage 50, et le dispositif d'obturation 56 est commandé en position ouverte, tel que représenté sur la figure 2, ce qui fait communiquer le conduit de vide interne 34 avec le circuit de pompage 50.

Le circuit de pompage 50 provoque alors une diminution de la pression uniquement à l'intérieur de la bouteille 12, jusqu'à la valeur finale interne pFint, apte à permettre la formation du plasma pour réaliser le traitement.

L'étape de traitement E2 peut alors être mise en oeuvre.

Pendant l'étape de traitement, le circuit de pompage 50 peut continuer de pomper à l'intérieur de la bouteille 12 pour maintenir la pression à sa valeur finale interne pFint.

La valeur finale externe pFext est maintenue dans la cavité 18 par une étanchéité adéquate de l'enceinte 16 et du conduit de vide externe 20.

On note que l'étape préliminaire E1 du procédé selon l'invention ne fait pas perdre de temps, par rapport au fonctionnement du procédé selon l'état de la technique, car les valeurs finales pFext, pFint sont obtenues plus rapidement en pompant indépendamment dans la cavité 18 puis dans la bouteille 12, plutôt qu'en pompant simultanément dans les deux éléments.

Selon une variante du procédé selon l'invention, pendant la phase de pompage externe P1, le circuit de pompage 50 diminue la pression dans la cavité 18 jusqu'à une valeur intermédiaire pMext qui est supérieure à la valeur finale externe pFext.

Une phase intermédiaire de pompage Pm est alors mise en oeuvre, entre la phase de pompage externe P1 et la phase de pompage interne P2, au cours de laquelle le dispositif d'obturation 56 et le dispositif d'obturation 52 sont ouverts simultanément, de sorte que le conduit de vide externe 20 et le conduit de vide interne 34 communiquent simultanément avec le circuit de pompage 50.

La phase intermédiaire de pompage Pm est mise en oeuvre jusqu'à ce que la pression dans la cavité 18 atteigne la valeur finale externe pFext.

Le dispositif d'obturation 52 est alors fermé et la phase de pompage interne P2 est mise en oeuvre.

L'invention est tout à fait applicable à des machines de traitement qui, au lieu de permettre le traitement d'un seul récipient par poste de traitement 14 permettraient le traitement de plusieurs récipients.

Par ailleurs, au lieu d'être réalisé partiellement dans le couvercle 32, donc dans une structure mobile, le conduit de vide interne 34 pourrait l'être dans une autre partie du poste de traitement 14.

## Revendications

1. Procédé de traitement d'au moins un récipient (12) visant à réaliser le dépôt d'un revêtement interne formant barrière au moyen d'un plasma micro-ondes, notamment en vue de permettre le conditionnement de liquides oxydo-sensibles dans le récipient (12), du type dans lequel le récipient (12) est disposé à l'intérieur d'une enceinte (16) de traitement hermétiquement fermée qui délimite une cavité (18) à l'extérieur du récipient (12) et qui est raccordée à un circuit de pompage (50) à vide par un conduit de vide externe (20), l'intérieur du récipient (12) étant raccordé au circuit de pompage (50) par un conduit de vide interne (34), du type comportant une étape préliminaire (E1) au cours de laquelle le circuit de pompage (50) provoque une diminution de la pression à l'intérieur de la cavité (18) jusqu'à une valeur déterminée dite valeur finale externe (pFext) et une diminution de la pression à l'intérieur du récipient (12) jusqu'à une valeur déterminée dite valeur finale interne (pFint) qui est inférieure à la valeur finale externe (pFext), l'étape préliminaire (E1) étant suivie d'une étape de traitement (E2) au cours de laquelle les valeurs finales (pFext, pFint) sont maintenues dans la cavité (18) et dans le récipient (12) pour permettre le dépôt du revêtement interne dans le récipient (12),
**caractérisé en ce que** l'étape préliminaire (E1) comporte successivement :
- une phase de pompage externe (P1), au cours de laquelle le conduit de vide interne (34) est fermé et le conduit de vide externe (20) est ouvert, le circuit de pompage (50) provoquant la diminution de la pression uniquement dans la cavité (18), jusqu'à une valeur intermédiaire (pMext) qui est supérieure à la valeur finale externe (pFext),
- une phase intermédiaire de pompage (Pm), entre la phase de pompage externe (P1) et une phase de pompage interne (P2), au cours de laquelle le conduit de vide externe (20) et le conduit de vide interne (34) sont ouverts simultanément de manière que le circuit de pompage (50) diminue simultanément la pression dans la cavité (18) et à l'intérieur du récipient (12), jusqu'à ce que la pression dans la cavité (18) atteigne la valeur finale externe (pFext), et :
- une phase de pompage interne (P2), au cours de laquelle le conduit de vide externe (20) est fermé et le conduit de vide interne (34) est ouvert, le circuit de pompage (50) provoquant la diminution de la pression uniquement à l'intérieur du récipient (12), jusqu'à la valeur finale interne (pFint).

2. Machine (10) de traitement de récipients (12) pour la mise en oeuvre du procédé selon la revendication précédente, comportant au moins un poste de traitement (14) pour au moins un récipient (12), chaque poste de traitement (14) comprenant :
- une enceinte (16) de traitement qui est prévue pour contenir le récipient (12) et qui délimite autour du récipient (12) une cavité (18) raccordée de manière étanche à un conduit de vide externe (20),
- et, un conduit de vide interne (34) raccordé de manière étanche à l'intérieur du récipient (12),
du type dans laquelle le conduit de vide externe (20) et le conduit de vide interne (34) sont raccordés à un circuit de pompage (50) à vide commun, le conduit de vide interne (34) communiquant avec le circuit de pompage (50) par l'intermédiaire d'un premier dispositif d'obturation (56) commandé et le conduit de vide externe (20) communiquant avec le circuit de pompage (50) par l'intermédiaire d'un second dispositif d'obturation (52) commandé,
**caractérisée en ce que** le conduit de vide externe (20) est raccordé directement au circuit de pompage (50), sans passer par le conduit de vide interne (34), et **en ce que** le premier dispositif d'obturation (56) est commandé de manière à permettre le pompage dans la cavité (18) indépendamment du pompage dans lé récipient (12).

3. Machine (10) selon la revendication précédente, **caractérisée en ce que** au moins un dispositif d'obturation (52, 56) est constitué par une soupape commandée par un système à came (58).

4. Machine (10) selon la revendication 2, **caractérisée en ce qu'**au moins un dispositif d'obturation (52, 56) est constitué par une électrovanne.

5. Machine selon la revendication 2, **caractérisée en ce que** le conduit de vide interne (34) raccordé de manière étanche à l'intérieur du récipient est partiellement contenu dans un couvercle (32) prévu pour fermer l'enceinte (16) de manière hermétique.

6. Machine selon la revendication 5, **caractérisée en ce que** un conduit de vide interne (34) communique avec le circuit de pompage par un orifice de raccordement (54) réalisé dans le couvercle, et le premier dispositif d'obturation (56) commandé est agencé dans cet orifice de raccordement (54) de façon à l'obturer ou à le libérer.

## Claims

1. A method for treating at least one container (12) aimed at depositing an internal coating forming a barrier by means of a microwave plasma, in particular with a view to enabling oxido-sensitive liquids to be packaged in the container (12), of the type in which the container (12) is disposed inside a hermetically sealed treatment chamber (16) which delimits a cavity (18) outside the container (12) and which is connected to a vacuum pumping circuit (50) by an external vacuum line (20), the interior of the container (12) being connected to the pumping circuit (50) by an internal vacuum line (34), of the type comprising a preliminary step (E1) during which the pumping circuit (50) produces a pressure reduction inside the cavity (18) to a set value called the final external value (pFext), and a pressure reduction inside the container (12) to a set value called the final internal value (pFint), which is lower than the final external value (pFext), the preliminary step (E1) being followed by a treatment step (E2) during which the final values (pFext, pFint) are maintained inside the cavity (18) and inside the container (12) so as to enable the internal coating to be deposited inside the container (12),
**characterized in that** the preliminary step (E1) comprises successively:
- an external pumping phase (P1), during which the internal vacuum line (34) is closed and the external vacuum line (20) is open, the pumping circuit (50) reduces the pressure inside the cavity (18) to an intermediate value (pMext) which is greater than the final external value (pFext),
- an intermediate pumping phase (Pm), between the external pumping phase (P1) and the internal pumping phase (P2), during which the external vacuum line (20) and the internal vacuum line (34) are opened simultaneously so that the pumping circuit (50) reduces the pressure simultaneously inside the cavity (18) and inside the container (12), until the pressure inside the cavity (18) reaches the final external value (pFext), and
- an internal pumping phase (P2), during which the external vacuum line (20) is closed and the internal vacuum line (34) is open, the pumping circuit (50) producing a pressure reduction only inside the container (12), to the final internal value (pFint).

2. A machine (10) for treating containers (12) for implementing the method as claimed in the preceding claim, comprising at least one treatment station (14) for at least one container (12), each treatment station (14) comprising:
- a treatment chamber (16) which is provided so as to contain the container (12) and which delimits, around the container (12), a cavity (18) connected in a leakproof manner to an external vacuum line (20),
- and, an internal vacuum line (34) connected in a leakproof manner to the interior of the container (12),
of the type in which the external vacuum line (20) and the internal vacuum line (34) are connected to a common vacuum pumping circuit (50), the internal vacuum line (34) communicating with the pumping circuit (50) via a first controlled closing device (56) and the external vacuum line (20) communicating with the pumping circuit (50) via a second controlled closing device (52),
**characterized in that** the external vacuum line (20) is directly connected to the pumping circuit (50) without passing through the internal vacuum line (34), and **in that** the first closing device (56) is controlled so as to enable the cavity (18) and the container (12) to be pumped independently of each other.

3. The machine (10) as claimed in the preceding claim, **characterized in that** at least one closing device (52, 56) consists of a valve controlled by a cam system (58).

4. The machine (10) as claimed in claim 2, **characterized in that** at least one closing device (52, 56) consists of a solenoid valve.

5. The machine as claimed in claim 2, **characterized in that** the internal vacuum line (34) connected in a leakproof manner to the interior of the container is partially contained in a cover (32) designed to close the chamber (16) hermetically.

6. The machine as claimed in claim 5, **characterized in that** an internal vacuum line (34) communicates with the pumping circuit via a connecting orifice (54) made in the cover, and the first controlled closing device (56) is arranged in this connecting orifice (54) so as to close or free it.

## Patentansprüche

1. Verfahren zur Behandlung mindestens eines Behälters (12) im Hinblick auf das Aufbringen eines inneren Sperrüberzugs mittels eines Mikrowellenplasmas, insbesondere um die Verpackung von sauerstoffempfindlichen Flüssigkeiten in dem Behälter (12) zu ermöglichen, wobei der Behälter (12) im Inneren einer hermetisch verschlossenen Behandlungskammer (16) angeordnet ist, welche außen am Behälter (12) einen Hohlraum (18) begrenzt, und die über eine externe Vakuumleitung (20)
an einen Vakuumpumpkreislauf (50) angeschlossen ist, wobei das Innere des Behälters (12) über eine innere Vakuumleitung (34) an den Pumpkreislauf (50) angeschlossen ist, wobei die innere Vakuumleitung (34) eine Vorstufe (E1) aufweist, im Verlaufe derer der Pumpkreislauf (50) eine Senkung des Druckes im Inneren des Hohlraumes (18) bis zu einem festgelegten Wert - dem sogenannten externen Endwert (pFext) - hervorruft, und eine Verringerung des Druckes im Inneren des Behälters (12) bis zu einem festgelegten Wert - dem sogenannten internen Endwert (pFint) - der unter dem externen Endwert (pFext) liegt, wobei der Vorstufe (E1) eine Behandlungsstufe (E2) folgt, im Verlaufe derer die Endwerte (pFext, pFint) in dem Hohlraum (18) und in dem Behälter (12) aufrecht erhalten werden, um die Aufbringung des inneren Überzugs in dem Behälter (12) zu ermöglichen,
**dadurch gekennzeichnet, dass** die Vorstufe (E1) nacheinander folgendes aufweist :
- eine externe Pumpphase (P1), im Verlaufe derer die interne Vakuumleitung (34) geschlossen ist und die externe Vakuumleitung (20) offen ist, wobei der Pumpkreislauf (50) die Verringerung des Druckes nur in dem Hohlraum (18) hervorruft, und zwar bis zu einem Zwischenwert (pMext), der höher ist als der externe Endwert (pFext),
- eine Zwischenpumpphase (Pm) zwischen der externen Pumphase (P1) und einer internen Pumpphase (P2), im Laufe derer die externe Vakuumleitung (20) und die interne Vakuumleitung (34) gleichzeitig offen sind, so dass der Pumpkreislauf (50) den Druck in dem Hohlraum (18) und im Inneren des Behälters (12) gleichzeitig herabsetzt, bis der Druck in dem Hohlraum (18) den externen Endwert (pFext) erreicht, und
- eine interne Pumpphase (P2), im Laufe derer die externe Vakuumleitung (20) geschlossen ist und die interne Vakuumleitung (34) offen ist, wobei der Pumpkreislauf (50) die Verringerung des Druckes nur im Inneren des Behälters (12) bis zu dem internen Endwert (pFint) hervorruft.

2. Maschine (10) zur Behandlung von Behältern (12) für die Ausführung des Verfahrens nach dem vorhergehenden Anspruch, die mindestens eine Behandlungsstation (14) für mindestens einen Behälter (12) besitzt, wobei jede Behandlungsstation (14) folgendes aufweist :
- eine Behandlungskammer (16), die den Behälter (12) enthalten soll, und die um den Behälter (12) herum einen Hohlraum (18) begrenzt, der luftdicht an eine externe Vakuumleitung (20) angeschlossen ist,
- und eine interne Vakuumleitung (34), die luftdicht an das Behälterinnere (12) angeschlossen ist,
wobei die externe Vakuumleitung (20) und die interne Vakuumleitung (34) an einen Pumpkreislauf (50) mit gemeinsamem Vakuum angeschlossen sind, wobei die interne Vakuumleitung (34) mittels einer ersten gesteuerten Verschlussvorrichtung (56) mit dem Pumpkreislauf in Verbindung steht, und die externe Vakuumleitung (20) mittels einer zweiten gesteuerten Verschlussvorrichtung (52) mit dem Pumpkreislauf in Verbindung steht,
**dadurch gekennzeichnet, dass** die externe Vakuumleitung (20) direkt an den Pumpkreislauf (50) angeschlossen ist, ohne über die interne Vakuumleitung (34) zu verlaufen, und dass die erste Verschlussvorrichtung (56) derart gesteuert ist, dass sie unabhängig von dem Pumpen in den Behälter (12) ein Pumpen in den Hohlraum (18) ermöglicht.

3. Maschine (10) nach dem vorhergehenden Anspruch, **dadurch gekennzeichnet, dass** mindestens eine Verschlussvorrichtung (52, 56) aus einem Ventil besteht, dass über ein Nockensystem gesteuert wird.

4. Maschine (10) nach Anspruch 2, **dadurch gekennzeichnet, dass** mindestens eine Verschlussvorrichtung (52, 56) aus einem Magnetventil besteht.

5. Maschine (10) nach Anspruch 2, **dadurch gekennzeichnet, dass** die interne Vakuumleitung (34), die luftdicht an das Behälterinnere angeschlossen ist, teilweise in einem Deckel (32) aufgenommen ist, um die Kammer (16) hermetisch zu verschließen.

6. Maschine (10) nach Anspruch 5, **dadurch gekennzeichnet, dass** eine interne Vakuumleitung (34) über eine Anschlussöffnung (54), die sich in dem Deckel befindet, mit dem Pumpkreislauf (50) in Verbindung steht, und die erste gesteuerte Verschlussvorrichtung (56) in dieser Anschlussöffnung (54) angeordnet ist, so dass sie diese verschließt oder freigibt.
